Europäisches Patentamt

European Patent Office

Office européen des brevets

(11) Publication number: **0 015 675**
**B1**

## (12) EUROPEAN PATENT SPECIFICATION

(45) Date of publication of patent specification: **23.05.84**

(21) Application number: **80300452.2**

(22) Date of filing: **15.02.80**

(51) Int. Cl.³: **H 01 L 29/78, H 01 L 21/86, G 11 C 11/34**

(54) Semiconductor memory device.

(30) Priority: **22.02.79 JP 20094/79**

(43) Date of publication of application:
**17.09.80 Bulletin 80/19**

(45) Publication of the grant of the patent:
**23.05.84 Bulletin 84/21**

(84) Designated Contracting States:
**DE FR GB**

(56) References cited:
**FR-A-2 144 904**
**FR-A-2 325 194**

**1978 INTERNATIONAL ELECTRON DEVICES MEETING, December 1978, Technical Digest; Washington US, N. SASAKI et al.: "Charge pumping SOS-MOS transistor memory" pages 356-359**

(73) Proprietor: **FUJITSU LIMITED**
**1015, Kamikodanaka Nakahara-ku**
**Kawasaki-shi Kanagawa 211 (JP)**

(72) Inventor: **Sasaki**
**Nobuo 14-240, Kawara-cho 1-chome**
**Saiwai-ku, Kawasaki-shi Kanagawa 211 (JP)**

(74) Representative: **Allman, Peter John et al**
**Marks and Clerk Scottish Life House Bridge Street**
**Manchester M3 3DP (GB)**

Courier Press, Leamington Spa, England.

# Description

## Technical field

The present invention relates to a semiconductor memory device and, more particularly, to a semiconductor memory device of a charge pumping MOS FET type.

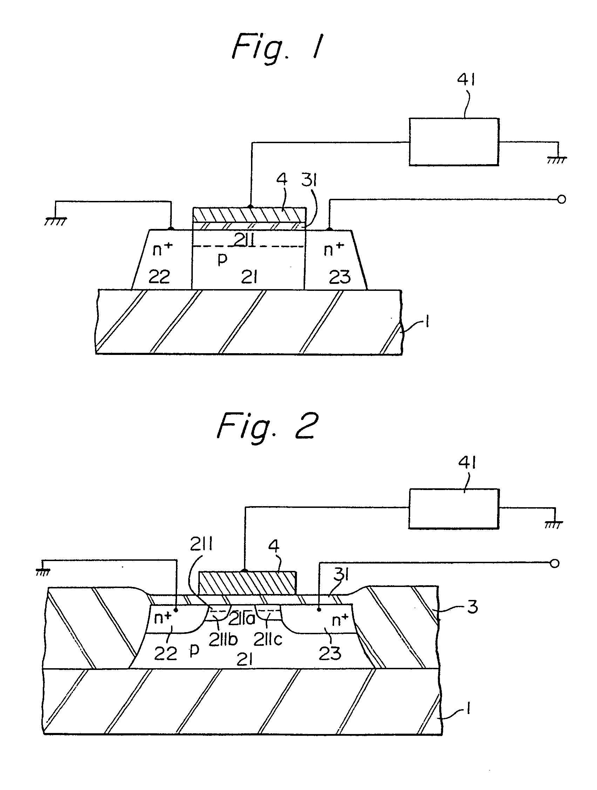

A prior art semiconductor memory device of the charge pumping MOS FET transistor type is illustrated in Figure 1. This semiconductor memory device comprises a single-crystalline insulating substrate 1 of, for example, sapphire, a p type semiconductor layer 21 of silicon having an $n^+$ type source region 22 and an $n^+$ type drain region 23, a gate insulating layer 31 of silicon dioxide and a gate electrode 4. A power source 41 is connected to the gate electrode 4. If the p type semiconductor layer 21 is negatively charged up with respect to the source region 22, information "1" is stored in the memory device and if the potential of the p type semiconductor layer 21 is equal to the potential of the source region 21, information "0" is stored in the memory device.

The writing-in of information "1" into the device of Figure 1 is effected as follows. Under the condition that the source region 22 is earthed and the drain region 23 is supplied with a positive voltage $V_{DD}$, after forming a channel 211 in the portion of the p type semiconductor layer 21 directly beneath the gate insulating layer 31 by applying a positive voltage greater than the threshold voltage $V_{th}$ to the gate electrode 4, the gate voltage is quickly caused to fall below the threshold voltage $V_{th}$. At that time, a portion of the electrons in the channel 211 is moved to the p type semiconductor layer 21 and is recombined with the positive holes in the layer 21 so that the number of the positive holes is reduced. Because of the reduction of the number of the positive holes, the layer 21 is caused to be negatively biased with respect to the potential of the source region 22. Because the bias is "reverse bias" of the p-n junction between the layer 21 and the source region, the layer 21 is maintained in the negatively biased potential from the potential of the source region 22. Accordingly, a writing-in of an information "1" is performed.

A reading-out of the information stored in the device of Figure 1 in accordance with the above described writing-in process is effected as follows. The above described bias can be regarded as a back gate bias. If there exists a back gate bias, the threshold voltage $V_{th}$ is enhanced. Thus, the threshold voltage $V_{th}$ of the device changes its value in accordance with the information "1" or the information "0" of the layer 21. When a voltage of, for example, 5V is applied to the gate electrode 4 and a voltage of, for example, 5V is applied to the drain electrode, the value of the current passing through the device is different in accordance with the written-in information "1" or "0". This is why the reading-out of the written-in information is possible.

An erasure of the written-in information "1" is effected by removing the negative bias from the layer 21. Alternatively, an erasure of the written-in information "1" is effected by applying a high voltage of, for example, 15V to the drain region 23 to cause an avalanche multiplication, so as to inject holes into the layer 21.

However, the prior art semiconductor memory device of Figure 1 has a disadvantage that, if the length of channel 211 is reduced in accordance with the reduction of the size of the semiconductor memory device, the greater part of the carriers in the channel 211 is caused to go back into either the source region 22 or the drain region 23 and, accordingly, the writing-in of the information becomes difficult and no effective charge pumping is carried out. This disadvantage occurs particularly in the case where the length of the channel 211 is reduced to shorter than 8 $\mu m$.

Prior art semiconductor memory devices of the charge pumping MOS FET type are described, for example, in the following two documents.

Nobuo Sasaki et al., "Charge Pumping SOS-MOS Transistor Memory", 1978 IEDM Technical Digest, Pages 356—359, December 1978.

Japanese Patent Application Laid-open No. 54-5635 (corresponding to U.S. Patent Application No. 960917).

Also, a memory device is known from French Patent No. 2144904 having a side region with a higher threshold voltage than a neighbouring storage region, which side region is used as a gate-zone for the write and read process of information.

The present invention has been proposed in order to eliminate the above described disadvantage.

In accordance with the present invention, there is provided a semiconductor memory device comprising a gate electrode (4) on a gate insulating layer (31) and a source region (22) and a drain region (23) formed in a semiconductor layer (21) having a predetermined conductivity type, being in an electrically floating state, and storing information in the form of a bias voltage with respect to the source region caused by charge carriers recombined in said semiconductor layer, wherein the information is read out via the value of the drain current at a predetermined drain and gate voltage, characterised in that:

in said semiconductor layer (21) between said source region (22) and said drain region (23) side regions (211b, 211c) are provided having a higher threshold voltage than a remaining central region (211a), so that those parts of a channel between said source region and said drain region which are located within said side regions (211b, 211c)

are pinched off first when the gate voltage is removed.

Figure 1 illustrates the structure of a prior art semiconductor memory device;

Figure 2 illustrates the structure of a semiconductor memory device in accordance with an embodiment of the present invention;

Figures 3A through 3F illustrate a process of the production of the semiconductor memory device of Figure 2, and;

Figures 4A through 4E illustrate an alternative process of the process of the production of the semiconductor memory device of Figure 2.

Description of the preferred embodiments

The structure of the semiconductor memory device in accordance with an embodiment of the present invention is illustrated in Figure 2. The semiconductor memory device of Figure 2 comprises a singlecrystalline insulating substrate 1, a p type semiconductor layer 21 of silicon, a $n^+$ type source region 22, a $n^+$ type drain region 23, a gate insulating layer 31 and a gate electrode 4. Between the source region 22 and the drain region 23, a central region 211a having the ordinary threshold voltage $V_{th1}$, and side regions 211b and 211c having a high threshold voltage $V_{th2}$ are formed.

In the structure illustrated in Figure 2, when the voltage applied to the gate electrode 4 is removed after said voltage is applied to the gate electrode for forming the channel 211, the portions of the channel 211 in the side regions 211b and 211c firstly pinch-off, while the portions of the channel 211 in the central region 211a are maintained to keep the electrons in the channel 211, so that these electrons are stored in the region 21. Thus, not all of the electrical charges in the channel go back to the source region 22 and the drain region 23, and accordingly, an effective writing-in of the information is achieved even when the length of channel is considerably short.

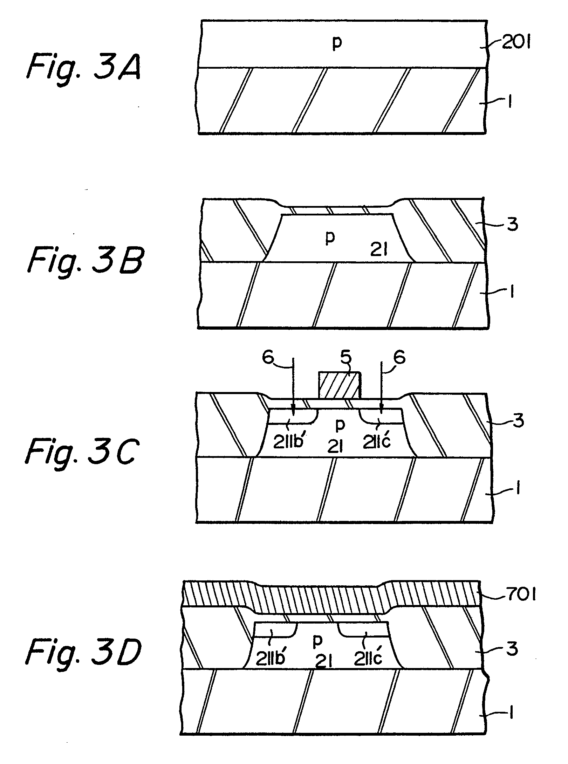

A process of the production of the semiconductor memory device of Figure 2 is illustrated in Figures 3A through 3F.

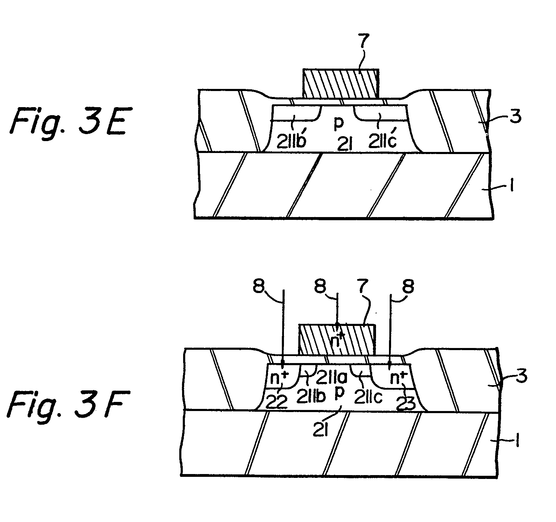

On a singlecrystalline insulating substrate 1 of sapphire, a p type semiconductor layer 201 of silicon is formed (Figure 3A). Covering the shaped p type semiconductor layer 21 of silicon, an insulating layer 3 of silicon dioxide is formed (Figure 3B). Using a masking layer 5 covering the portion in which the central region 211a (Figure 3F) is to be formed, boron ions 6 are implanted into the regions 211b' and 211c' by the ion implantation process (Figure 3C). The regions 211b' and 211c' have an increased threshold voltage $V_{th2}$. After the above mentioned ion implantation process, a layer 701 of polycrystalline silicon is formed (Figure 3D), and a gate electrode 7 is shaped by the patterning process, which is applied to the layer of polycrystalline silicon, to cover the portion in which the side regions 211b and 211c, and the central region 211a (Figure 3F) are to be situated (Figure 3E). Then, another ion implantation 8 is effected to form the $n^+$ type gate electrode 7, the $n^+$ type source region 22 and the $n^+$ type drain region 23 (Figure 3F).

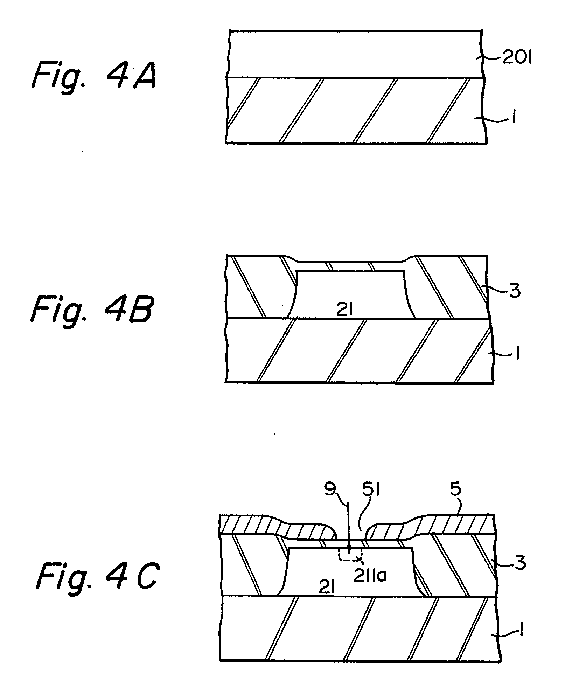

An alternative process of the production of the semiconductor memory device of Figure 2 is illustrated in Figures 4A through 4E.

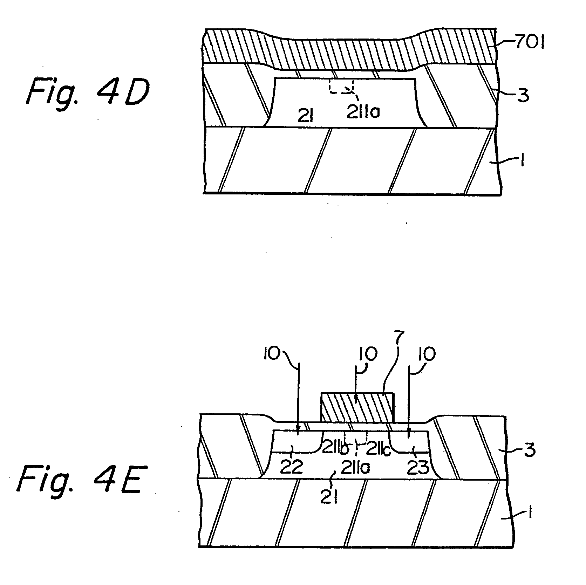

On a single-crystalline insulating substrate 1 of sapphire, a p type semiconductor layer 201 of silicon is formed (Figure 4A). Covering the shaped p type semiconductor layer 21 of silicon, an insulating layer 3 of silicon dioxide is formed (Figure 4B). Using a masking layer 5 covering the insulating layer 3 and having an aperture 51 corresponding to the central region 211a which is to be formed as illustrated in Figure 4E, an ion implantation 9 is effected to implant n type impurities of, for example, phosphorus into the central region 211a to reduce the threshold voltage of the central region 211a. After that, a layer 701 of polycrystalline silicon is formed (Figure 4D) and, then, a gate electrode 7 is shaped by the patterning process, which is applied to the layer of polycrystalline silicon, to cover the portion in which the side regions 211b and 211c, and the central region 211a are to be situated. Finally, another ion implantation 10 is effected to form the $n^+$ type gate electrode 7, the $n^+$ type source region 22 and the $n^+$ type drain region 23 (Figure 4E).

Although in the above described embodiments of the present invention, the conductivity type of the semiconductor layer 21 is selected as p type, it is, of course, possible to select n type as the conductivity type of the semiconductor layer 21.

**Claims**

1. A semiconductor memory device comprising a gate electrode (4) on a gate insulating layer (31) and a source region (22) and a drain region (23) formed in a semiconductor layer (21) having a predetermined conductivity type, being in an electrically floating stage, and storing information in the form of a bias voltage with respect to the source region caused by charge carriers recombined in said semiconductor layer, wherein the information is read out via the value of the drain current at a predetermined drain and gate-voltage, characterised in that:

in said semiconductor layer (21) between said source region (22) and said drain region (23) side regions (211b, 211c) are provided having a higher threshold voltage than a remaining central region (211a), so that those parts of a channel between said source region and said drain region which are located within said side regions (211b, 211c) are pinched off first when the gate voltage is removed.

2. A process for producing a semiconductor memory device defined in claim 1 comprising the steps of:

forming a semiconductor layer (201) having a predetermined conductivity type on an insulating substrate (1);

covering with a masking layer (5) the portion of said semiconductor layer in which said central region is to be formed;

applying a first ion implantation (6) to uncovered portions of said semiconductor layer;

forming a gate electrode (7) on an insulating layer (3) on said semiconductor layer, and;

applying a second ion implantation (8) to said gate electrode and uncovered portions of said semiconductor layer (Figure 3A—3F).

3. A process for producing a semiconductor memory device defined in claim 1 comprising the steps of:

forming a semiconductor layer (201) having a predetermined conductivity type on an insulating substrate;

covering said semiconductor layer with a masking layer (5) including an aperture (51), said aperture corresponding to the portion of said semiconductor layer in which said central region (211a) is to be formed;

applying a first ion implantation (9) to said portion of the semiconductor layer corresponding to said aperture;

forming a gate electrode (7) on an insulating layer on said semiconductor layer, and;

applying a second ion implantation (10) to said gate electrode and uncovered portions of said semiconductor layer (Figure 4A—4E).

**Patentansprüche**

1. Halbleiterspeichervorrichtung mit einer Gateelektrode (4) auf einer Gateisolierschicht (31) und einer Sourcezone (22) und einer Drainzone (23), welche in einer Halbleiterschicht (21) ausgebildet sind und eine vorbestimmte Leitfähigkeitsart haben und in einem elektrisch schwebenden Zustand sind und Information in Form einer Vorspannung in Bezug auf die Sourcezone speichern, verursacht durch Ladungsträger, welche in der genannten Halbleiterschicht rekombiniert sind, bei welcher die Information über den Wert des Drainstromes bei vorbestimmter Drainund Gatespannung ausgelesen wird, dadurch gekennzeichnet,

daß in der genannten Halbleiterschicht (21) zwischen der genannten Sourcezone (22) und der genannten Drainzone (23) Seitenzonen (211b, 211c) vorgesehen sind, welche eine höhere Schwellwertspannung als die verbleibende Zentralzone (211a) aufwisen, so daß die Teile eines Kanals zwischen der genannten Sourcezone und der genannten Drainzone, welche innerhalb der genannten Seitenzonen (211b, 211c) angeordnet sind, bei Entfernung der Gatespannung zuerst abgeschnürt werden.

2. Verfahren zur Herstellung einer Halbleiterspeichervorrichtung nach Anspruch 1, gekennzeichnet durch die folgenden Schritte:

Ausbildung einer Halbleiterschicht (201) von vorbestimmter Leitfähigkeitsart auf einem isolierenden Substrat (1);

Bedecken des Teils der Halbleiterschicht, in welcher die genannte zentrale Zone ausgebildet werden soll, mit einer Maskenschicht (5);

Anwendung einer ersten Ionenimplantation (6) auf unbedeckte Abschnitte der genannten Halbleiterschicht;

Ausbildung einer Gateelektrode (7) auf einer Isolierschicht (3) auf der genannten Halbleiterschicht, und

Anwendung einer zweiten Ionenimplantation (8) auf die genannte Gateelektrode und unbedeckte Abschnitte der genannten Halbleiterschicht (Figure 3A—3F).

3. Verfahren zur Herstellung einer Halbleiterspeichervorrichtung nach Anspruch 1, gekennzeichnet durch die folgenden Schritte:

Bildung einer Halbleiterschicht (201) mit vorbestimmter Leitfähigkeitsart auf einem isolierenden Substrat;

Bedecken der genannten Halbleiterschicht mit einer Maskenschicht (5), welche eine Öffnung (51) aufweist, welche dem Abschnitt der genannten Halbleiterschicht entspricht, in dem die genannte zentrale Zone (211a) gebildet werden soll;

Anwendung einer ersten Ionenimplantation (9) auf den genannten Abschnitt der Halbleiterschicht, welcher der Öffnung entspricht;

Bildung einer Gateelektrode (7) auf einer Isolierschicht auf der genannten Halbleiterschicht, und

Anwendung einer zweiten Ionenimplantation (10) auf die genannte Gateelektrode und unbedeckte Abschnitte der genannten Halbleiterschicht (Figure 4A—4E).

**Revendications**

1. Dispositif de mémorisation à semiconducteur comprenant une électrode de grille (4) sur une couche isolante de grille (31) et une région de source (22) et une région de drain (23) formées dans une couche semi-conductrice (21) ayant un type de conductivité prédéterminé, se trouvant dans un état électriquement flottant, et emmagasinant l'information sous la forme d'une tension de polarisation relative à la région de source produite par des porteurs de charge recombinés dans ladite couche semi-conductrice, où l'information est lue par l'intermédiaire de la valeur du courant de drain pour une tension prédéterminée de drain et de grille, caractérisée en ce que:

dans ladite couche semi-conductrice (21) entre ladite région de source (22) et ladite région de drain (23), sont prévues des régions latérales (211*b*, 211*c*) possédant une tension de seuil supérieure à celle d'une région central restante (211*a*), si bien que les parties d'un canal se trouvant entre ladite région de source et ladite région de drain qui sont situées à l'intérieur desdites régions latérales (211*b*, 211*c*) subissent un effet de pincement dès que la tension de grille est retirée.

2. Procédé de production d'un dispositif de mémorisation à semi-conducteur défini à la revendication 1, comprenant les opérations suivantes:

former une couche semi-conductrice (201) possédant un type prédéterminé de conductivité sur un substrat isolant (1);
courvir d'une couche de masquage (5) la partie de la couche semi-conductrice dans laquelle ladite région central doit être formée;
appliquer une première implantation ionique (6) à des parties dé couvertes de ladite couche semi-conductrice;

former une électrode grille (7) sur une couche isolante (3) se trouvant sur ladite couche semiconductrice; et
appliquer une deuxième implantation ionique (8) à ladite électrode de grille et aux parties découvertes de ladite couche semiconductrice (figures 3A—3F).

3. Procédé de production d'un dispositif de mémorisation à semi-conducteur défini à la revendication 1, comprenant les opérations suivantes:

former une couche semi-conductrice (201) possedant un type prédéterminé de conductivité sur un substrat isolant;
couvrir ladite couche semi-conductrice d'un couche de masquage (5) comportant une ouverture (51), ladite ouverture correspondant à la partie de ladite couche semiconductrice dans laquelle ladite région centrale (211*a*) doit être formée;
appliquer une première implantation ionique (9) à ladite partie de la couche semi-conductrice correspondant à ladite ouverture;
former une électrode de grille (7) sur une couche isolante se trouvant sur ladite couche semi-conductrice; et
appliquer une deuxième implantation ionique (10) à ladite électrode de grille et aux parties découvertes de ladite couche semi-conductrice (figures 4A—4E).

# Fig. 1

# Fig. 2

Fig. 3A

Fig. 3B

Fig. 3C

Fig. 3D

Fig. 3 E

Fig. 3 F

Fig. 4A

201

1

Fig. 4B

21

3

1

9    51    5

Fig. 4C

211a

21

3

1

Fig. 4D

Fig. 4E